Europäisches Patentamt

European Patent Office

Office européen des brevets

(19)

(11) **EP 0 915 543 A1**

(12) **DEMANDE DE BREVET EUROPEEN**

(43) Date de publication:
**12.05.1999 Bulletin 1999/19**

(51) Int Cl.$^6$: **H01S 3/25**

(21) Numéro de dépôt: **98402772.2**

(22) Date de dépôt: **09.11.1998**

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: **10.11.1997 FR 9714101**

(71) Demandeur: **ALCATEL**
**75008 Paris (FR)**

(72) Inventeurs:
- **Salet, Paul**
  **92140 Clamart (FR)**
- **Gerard, Franck**
  **78180 Montigny le Bretonneux (FR)**

(74) Mandataire: **Fournier, Michel Robert Marie et al**
**COMPAGNIE FINANCIERE ALCATEL**
**Dépt. Propriété Industrielle,**
**30, avenue Kléber**
**75116 Paris (FR)**

(54) **Amplificateur optique semi-conducteur et source laser intégrée l'incorporant**

(57) Pour éviter les phénomènes d'autofocalisation et d'astigmatisme de l'onde amplifiée, l'amplificateur comporte successivement :

- un segment d'entrée (SE) muni d'un guide d'entrée (GE) apte à guider une onde d'entrée monomode,
- un segment de diffraction (SD) comprenant un premier milieu transparent (5) pour ladite onde d'entrée monomode et apte à l'élargir,
- un segment de collimation (SC), et
- un segment d'amplification (SA) muni d'un guide amplificateur (GA) de largeur supérieure à celle dudit guide d'entrée (GE).

L'amplificateur permet de réaliser une source laser de forte puissance fournissant une onde à mode fondamental élargi.

Application pour produire les ondes de pompe d'amplificateurs optiques à fibre.

FIG_3

EP 0 915 543 A1

# Description

L'invention se situe dans le domaine des composants optiques semi-conducteurs et concerne plus particulièrement les amplificateurs et les sources laser destinés à délivrer une forte puissance optique continue.

Les composants de ce type sont par exemple utilisés pour produire les ondes de pompe d'amplificateurs optiques à fibre, tels que ceux dopés à l'erbium ("EDFA").

Notamment pour cette application, on cherche à augmenter le gain des amplificateurs semi-conducteurs ainsi que la puissance optique qu'ils sont capables de fournir.

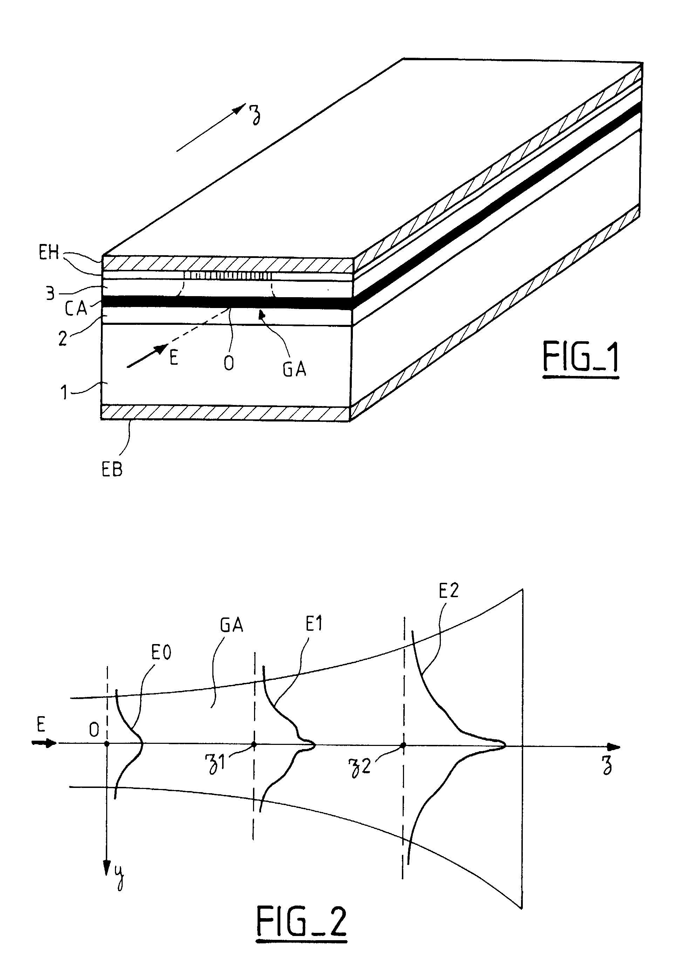

La figure 1 montre un exemple d'amplificateur optique semi-conducteur conventionnel. Il est essentiellement constitué d'une couche active CA confinée entre des couches tampon inférieure 2 et supérieure 3. Des électrodes inférieure EB et supérieure EH polarisées permettent d'injecter à travers la couche active CA un courant électrique transversal de pompage.

La région de la couche active dans laquelle la puissance optique reste confinée est appelée guide amplificateur (ou guide actif). Cette région est définie par la structure verticale du composant. La structure peut être à guidage par gradient d'indice. La couche active est alors délimitée latéralement pour définir la largeur du guide. La structure peut être aussi à guidage par le gain. Dans ce cas, la couche active est plus large que le guide et la largeur de ce dernier est définie par la forme des électrodes qui localisent le courant injecté, comme dans l'exemple représenté sur la figure 1.

Le gain peut être augmenté en allongeant le guide actif de l'amplificateur, mais cette solution est limitée à cause du phénomène de saturation du gain du milieu amplificateur semi-conducteur.

On sait en effet que le gain dépend à la fois de la longueur L du guide actif et du coefficient de gain g (appelé aussi "gain matériau") du milieu amplificateur. Ce coefficient g est défini par :

$$dP/dz = g.P$$ , où z est la position d'un point le long de l'axe longitudinal Oz du milieu amplificateur et P est la densité de puissance optique en ce point.

Le gain G du guide actif (défini ici comme le rapport des densités de puissance respectivement à la sortie et à l'entrée du guide) vérifie donc :

$$G = \int g.dz$$ , l'intégrale étant calculée le long de l'axe longitudinal Oz entre l'entrée ($z = 0$) et la sortie ($z = L$) du guide.

Or, le phénomène de saturation du gain a pour effet que le gain matériau g diminue lorsque la densité de puissance optique augmente.

Pour une onde continue, on a en première approximation :

$$g = g0/(1+P/Ps)$$ , où g0 est le coefficient de gain non saturé (ou valeur de pic) et Ps est la puissance de saturation du milieu. Le coefficient g0 a une valeur qui dépend directement de la densité de porteurs au point considéré, donc de la densité de courant électrique injecté en ce point.

Ainsi, pour un type d'amplificateur donné, l'augmentation de la longueur L au delà d'une certaine valeur entraîne une augmentation relative de gain très faible.

Pour palier à cette limitation, on a d'abord cherché à augmenter la puissance de saturation Ps en optimisant la composition des couches semi-conductrices constitutives de l'amplificateur, par exemple en adoptant des structures actives complexes telles que les puits quantiques multiples.

On a proposé par ailleurs des amplificateurs à structure évasée consistant à élargir le guide amplificateur dans le sens de la propagation de l'onde amplifiée. On peut augmenter ainsi la puissance de sortie sans augmenter la densité de puissance optique moyenne dans le guide. Cette solution permet bien d'augmenter le gain mais elle est limitée par la nécessité en général de conserver une onde de sortie monomode. De plus, l'onde de sortie d'un tel amplificateur présente un fort astigmatisme qui rend difficile son couplage avec une fibre optique.

Indépendamment des deux approches précédentes, on cherche aussi à avoir un coefficient de gain non saturé g0 maximum en ajustant le courant de pompage injecté dans la couche active.

Quelle que soit la solution choisie, on reste confronté à un autre problème lié à la forme de l'onde amplifiée. Ainsi, dans le cas par exemple d'une onde monomode, l'amplitude de son champs électrique, donc la densité de puissance optique, varie le long de chaque axe latéral Oy du guide en présentant un maximum au centre du guide. On peut assimiler cette distribution de champs à celle représentée par une courbe de Gauss. Comme le montre schématiquement la figure 2, on constate alors qu'à partir d'un certain niveau d'amplification l'onde E0, E1, E2 présente un pic d'amplitude au voisinage de l'axe longitudinal Oz du guide et ce pic s'amplifie au fur et à mesure de la propagation. Il en résulte une dégradation de l'efficacité du couplage de l'onde de sortie avec une fibre monomode.

Pour expliquer ce phénomène, il convient de rappeler qu'une diminution de densité de porteurs s'accompagne d'une saturation de gain accrue. Comme l'injection de courant est uniforme dans tout le guide actif, la forme gaussienne de l'onde implique que la densité de porteurs est plus faible en son centre que vers ses bords latéraux, ce qui devrait entraîner une diminution relative de l'amplitude au centre du guide. Toutefois, la diminution de densité de porteurs se traduit également par une augmentation de l'indice qui a pour effet de confiner l'onde vers l'axe longitudinal Oz du guide, et c'est ce dernier effet qui prédomine. On assiste donc à un phénomène d'autofocalisation de l'onde amplifiée.

L'invention a pour but d'échapper aux limitations des solutions évoquées ci-dessus. Pour cela, elle propose une solution permettant d'augmenter très fortement le gain sans phénomène d'autofocalisation, sans astigmatisme de l'onde de sortie, tout en restant compatible avec n'importe quelle technologie ou structure amplificatrice semi-conductrice.

Plus précisément, l'invention a pour objet un amplificateur optique semi-conducteur comportant successivement :

- un segment d'entrée muni d'un guide d'entrée apte à guider une onde d'entrée monomode,
- un segment de diffraction comprenant un premier milieu transparent pour ladite onde d'entrée monomode et apte à l'élargir,
- un segment de collimation, et
- un segment d'amplification muni d'un guide amplificateur de largeur supérieure à celle dudit guide d'entrée.

Ainsi, le segment de diffraction crée une onde sphérique élargie, ce qui à pour effet de diminuer la densité de puissance. Le segment de collimation a ensuite pour rôle de transformer cette onde sphérique en une onde plane pouvant être amplifiée dans le guide amplificateur large sans poser de problèmes d'autofocalisation ou d'astigmatisme.

Selon une première possibilité, le segment de collimation comprend un dioptre séparant ledit premier milieu d'un second milieu transparent d'indice effectif inférieur à celui du premier milieu.

Selon une autre possibilité, le segment de collimation comprend un dioptre séparant ledit premier milieu d'un troisième milieu transparent d'indice effectif supérieur à celui du premier milieu.

Cette dernière disposition est particulièrement intéressante si le troisième milieu peut être celui du guide amplificateur du segment d'amplification car elle permet d'économiser une étape d'épitaxie lors de la fabrication. Il convient cependant que l'indice du guide amplificateur reste sensiblement constant. C'est le cas en particulier si le guide est constitué d'une couche active à puits quantiques car seuls ces derniers ont un indice sensible au courant électrique qui les traverse et, compte tenu de leur faible épaisseur relative, leur influence sur l'indice effectif du guide amplificateur est négligeable.

Comme généralement le guide amplificateur est constitué d'une couche active guidante de faible épaisseur, le premier milieu sera alors avantageusement constitué d'une couche guidante couplée à la couche active et le dioptre possédera une surface cylindrique à génératrice perpendiculaire à cette couche guidante.

L'invention a également pour objet un oscillateur laser utilisant un amplificateur optique semi-conducteur tel que défini précédemment. Il suffit pour cela d'associer à l'amplificateur des moyens réflecteurs pour former une cavité résonante. De façon connue en soi, ces moyens réflecteurs peuvent être les facettes clivées du composant constituant les faces avant et arrière de l'amplificateur, des réflecteurs de Bragg distribués ("DBR") ou un réflecteur à contre-réaction distribuée ("DFB").

Outre l'absence d'autofocalisation, un oscillateur de ce type présente l'intéressante possibilité d'éviter l'apparition de modes non fondamentaux, même si la largeur du guide amplificateur était normalement suffisante pour les supporter. Il suffit pour cela que le guide d'entrée soit dimensionné pour être monomode et de longueur suffisante pour constituer un filtre de mode.

Selon une autre approche consistant à séparer la fonction d'amplification de la fonction d'oscillateur, l'invention a aussi pour objet une source laser intégrée, caractérisée en ce qu'elle est comporte un amplificateur optique semi-conducteur tel que défini précédemment et en ce que ledit guide d'entrée est constitué d'un milieu amplificateur associé à des moyens réflecteurs pour former une cavité résonante d'un oscillateur laser.

Le guide d'entrée a donc pour fonction de produire le mode fondamental étroit d'une onde laser. Ce mode est ensuite élargi puis amplifié par l'amplificateur. Grâce au segment de collimation, on peut obtenir une largeur du mode bien supérieure à celle produite par un guide monomode étroit. Ainsi, la densité de puissance dans le segment d'amplification peut être réduite, ce qui permet d'éviter les problèmes liés à la saturation, tout en autorisant une puissance de sortie élevée.

Par rapport à une source laser utilisant un oscillateur à guide monomode étroit couplé à un amplificateur à guide évasé, cette solution permet d'élargir davantage l'onde de sortie tout en la maintenant monomode. Par ailleurs, l'absence de guide évasé évite que cette onde présente un fort astigmatisme qui rend difficile son couplage avec une fibre optique.

D'autres aspects et avantages de l'invention apparaîtront dans la suite de la description en référence aux figures.

- La figure 1 représente schématiquement en perspective un exemple d'amplificateur optique semi-conducteur.
- La figure 2 est une vue de dessus d'un guide amplificateur évasé.
- La figure 3 est une vue de dessus d'un premier mode de réalisation d'un amplificateur selon l'invention.
- La figure 4 est une vue en coupe selon le plan vertical passant par l'axe longitudinal de l'amplificateur de la figure 3.
- La figure 5 est une vue en coupe selon un plan vertical transversal de l'amplificateur de la figure 3.
- La figure 6 est un schéma pour expliquer comment déterminer la forme du dioptre du premier mode de réalisation.
- La figure 7 est une vue de dessus d'un second mode de réalisation d'un amplificateur selon l'invention.

- La figure 8 est une vue en coupe selon le plan vertical passant par l'axe longitudinal de l'amplificateur de la figure 7.
- La figure 9 est une vue en coupe selon un plan vertical transversal de l'amplificateur de la figure 7.
- La figure 10 est un schéma pour expliquer comment déterminer la forme du dioptre du second mode de réalisation.
- La figure 11 est une vue de dessus d'une source laser intégrée selon l'invention.
- La figure 12 est une vue en coupe selon le plan vertical passant par l'axe longitudinal de la source laser de la figure 11.

L'exemple de structure d'amplificateur optique semi-conducteur représenté sur la figure 1 a déjà été décrit pour l'essentiel dans l'introduction ci-dessus. De façon non limitative, une telle structure peut être utilisée pour réaliser les segments d'amplification de l'amplificateur et de la source laser selon l'invention. On a ici une structure à guidage par le gain : la largeur du guide GA est définie par la largeur de la partie centrale conductrice de l'électrode supérieure EH. Ainsi, une onde optique d'entrée monomode E dirigée vers la face avant de l'amplificateur va se propager en restant confinée dans le guide et centrée sur l'axe longitudinal Oz qui passe par son milieu O.

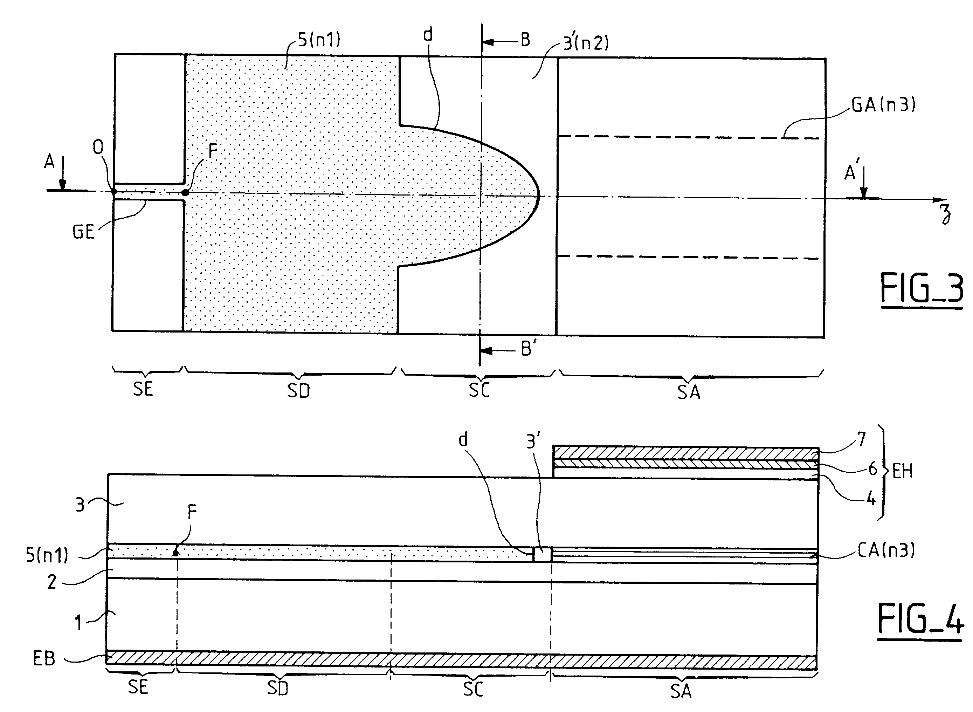

Un premier mode de réalisation de l'amplificateur selon l'invention est représenté sur les figures 3 à 5. L'amplificateur est représenté ici sous la forme d'un composant intégré isolé, mais la même structure pourrait être utilisée pour réaliser un composant plus complexe.

La figure 3 fait apparaître en vue de dessus les différentes zones guidantes du composant. La figure 4 qui représente une coupe selon le plan vertical A A' passant par l'axe longitudinal Oz du composant montre sa structure verticale.

L'amplificateur est constitué d'un segment d'entrée SE, d'un segment de diffraction SD, d'un segment de collimation SC et d'un segment d'amplification SA.

Le segment d'entrée SE comporte un guide d'entrée GE de faible largeur et constitué d'un milieu 5. Le segment de diffraction SD d'indice effectif nI est couplé d'un côté au segment d'entrée SE et de l'autre coté au segment d'amplification SA par l'intermédiaire du segment de collimation SC. La milieu guidant du segment de diffraction SD à la même composition que celui du guide d'entrée GE. Ce milieu 5 commun est représenté en pointillés sur les figures.

Le segment de collimation SC comprend essentiellement un dioptre d qui constitue la frontière entre le milieu 5 et un milieu 3' qui présente un indice effectif n2 inférieur à l'indice effectif nI du segment de diffraction SD.

Le segment d'amplification SA est couplé par un de ses côtés au segment de collimation SC, son côté opposé constituant la face arrière du composant par laquelle l'onde amplifiée est émise. Le milieu guidant du segment d'amplification SA est constitué par la couche active CA d'indice effectif n3.

La structure verticale du segment d'amplification SA représenté sur la figure 4 est constituée successivement de bas en haut d'une électrode inférieure EB, d'un substrat 1, d'une couche tampon inférieure 2, d'une couche active CA, d'une couche tampon supérieure 3 et d'une électrode supérieure EH. L'électrode EH est constituée d'une couche de contact 4 sur laquelle sont déposées des couches métalliques 6, 7. La couche active CA est présente sur toute la largeur du composant et le guide amplificateur GA est défini par une gravure localisée de la couche de contact 4 de façon à ne laisser subsister qu'une bande conductrice correspondant à la largeur du guide.

Pour les segments d'entrées SE et de diffraction SD, on retrouve une structure analogue à la différence près que la couche active est remplacée par une couche guidante 5 non amplificatrice et transparente pour les longueurs d'onde d'utilisation. Son indice est supérieur aux indices des milieux qui l'entoure. Par ailleurs, le guide d'entrée GE est de type enterré et sa largeur est choisie suffisamment petite pour imposer un mode fondamental pour les longueurs d'ondes d'utilisation.

Le milieu 3' du segment de collimation SC a un indice inférieur à celui de la couche 5. Il peut avoir la même composition que le substrat 1.

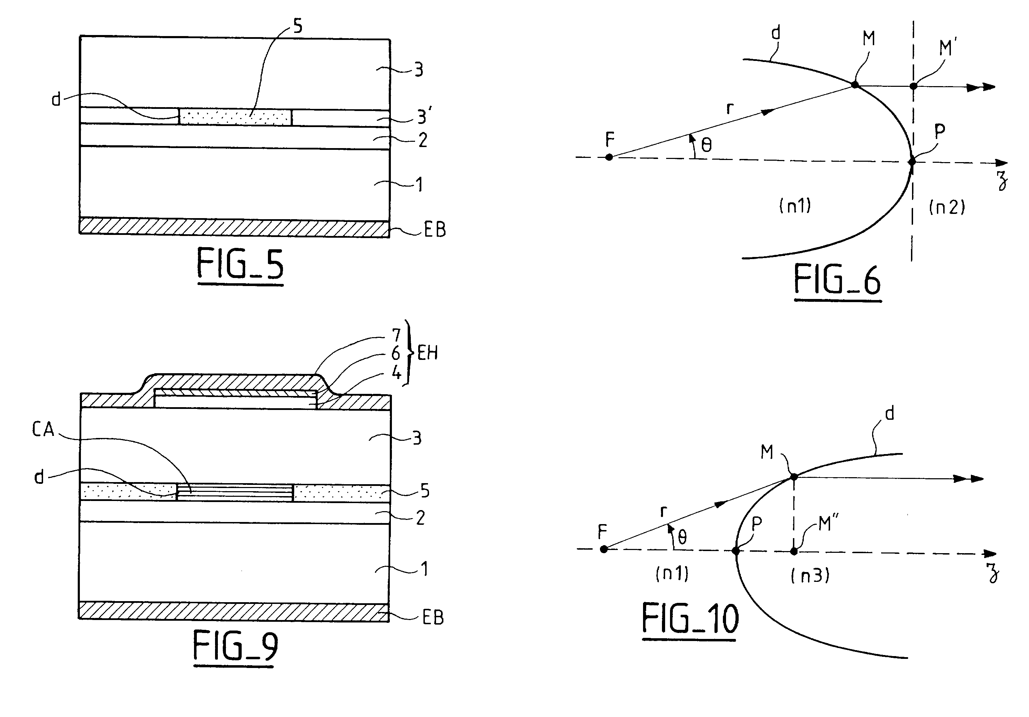

La figure 5 représente une coupe selon un plan vertical transversal BB' situé au niveau du dioptre d.

Comme les couches guidantes sont généralement très minces par rapport aux dimensions horizontales de l'onde propagée, le dioptre s'inscrit en pratique dans une surface cylindrique à génératrice verticale. La courbe directrice du cylindre définit donc le dioptre.

La figure 6 permet d'expliquer la façon de déterminer cette courbe. Sur la figure, F représente le point d'entrée du segment de diffraction SD, P étant un point d'intersection du dioptre d et du plan vertical AA'. La courbe recherchée est alors constituée de l'ensemble des points M tel que :

n1.FM + n2.MM' = n1.FP , où M' est la projection de M sur le plan vertical transversal passant par P.

En introduisant les coordonnées polaires r = FM et $\theta$ l'angle entre FM et FP, en posant FP = p, on a :

$$n1.(p-r) = n2.(p-r.\cos\theta)$$

n1 étant supérieur à n2, cette équation est celle d'une ellipse de foyer F qui dépend des seuls paramètres n1, n2 et FP. Ainsi, connaissant n1 et n2 et en fixant une largeur voulue du guide amplificateur GA, on peut trouver au moins une valeur de FP qui convient et calculer la forme exacte du dioptre correspondant.

Le composant peut être réalisé sur un substrat d'éléments III-V et à titre d'illustration non limitative, on a choisi un substrat en phosphure d'indium InP.

La réalisation sur le substrat 1 des couches 2, CA, 5, 3, 3' et 4 fait appel à des techniques d'épitaxie bien connues, comme par exemple le procédé d'épitaxie par jets moléculaires ("MBE").

Pour réaliser le dioptre, on a recours à une technique connue dite de couplage bout à bout ("butt-coupling") couramment utilisée notamment dans la fabrication des lasers à modulateur intégrés ("ILM"). Cette technique est par exemple décrite dans le brevet européen EP-A-664568, publié le 26 juillet 1995 et qui correspond au brevet américain US-A-5 646 064, publié le 8 juillet 1997. On rappelle que la technique de couplage bout à bout permet de former des couches semi-conductrices de compositions et de formes quelconques et disposées avec précision dans des plans horizontaux choisis, ce qui permet par exemple de bien coupler ces couches entre elles.

Grâce à cette technique on peut donc réaliser le dioptre d par formations localisées des couches 5 et 3' à l'aide d'un masque dont le dessin reproduit la courbe définie ci-dessus.

Pour fabriquer l'électrode EH, on peut procéder de la façon suivante. Après avoir formé une couche de contact 4 ternaire InGaAs sur toute la surface du composant, on dépose sur celle-ci une couche métallique 6 directement sur toute la surface de la couche de contact 4. La couche métallique 6 est constituée par exemple de tungstène. Le dépôt peut être réalisé par un procédé connu d'évaporation sous vide.

On forme alors un masque de résine au moyen d'un procédé photolithographique conventionnel. La forme du masque sert à définir la zone conductrice de l'électrode EH, donc la largeur du guide amplificateur GA.

On grave ensuite à travers ce masque successivement les couches 6 et 4. Dans le cas du tungstène, on peut utiliser un procédé connu de gravure par ions réactifs ("RIE") à base d'hexafluorure de tungstène. Pour la couche de contact 4, on peut aussi employer un procédé de gravure par ions réactifs, à base de méthane et d'hydrogène pour InGaAs.

On enlève alors la résine et on effectue un recuit (à 550°C dans le cas de l'InP) destiné à diminuer la résistivité à la frontière entre la couche de contact 4 et la couche métallique 6.

On dépose enfin sur toute la surface du composant une couche de métallisation 7 constituée par exemple d'une succession de couches de titane, de platine et d'or. Comme pour la couche métallique 6 les dépôts peuvent être réalisés par des procédés d'évaporation sous vide.

Comme on a une structure à guide non enterré (guidage par le gain), on procède ensuite à une implantation ionique (ions d'hydrogène) à travers la couche de métallisation et localisée sur les bords latéraux du composant.

A titre d'exemple pour une longueur d'onde de fonctionnement de 1,48 µm, on peut prendre les caractéristiques de dimensionnement suivantes :

- substrat 1 d'InP dopé n ($2.10^{18}$ électrons par $cm^3$) de 10 µm d'épaisseur;
- couche tampon inférieure 2 de mêmes composition et dopage que le substrat, ayant une épaisseur d'environ 0,5 µm ;
- couche guidante 5 du guide d'entrée GE et du segment de diffraction SD d'indice effectif n1 = 3,25 : en alliage quaternaire InGaAsP non dopée, dont la composition est choisie pour présenter une longueur d'onde caractéristique (longueur d'onde de "gap") égale à 1,10 µm, de 40nm d'épaisseur;
- milieu 3' de mêmes composition et dopage que le substrat, d'indice effectif n2 = 3,18
- couche active CA d'indice effectif n3 = 3,40, comportant :

    - une couche de confinement inférieure quaternaire InGaAsP dopée n, dont la composition est choisie pour présenter une longueur d'onde caractéristique égale à 1,18 µm, de 40nm d'épaisseur,
    - une structure à puits quantiques contraints, constituée de quatre puits et trois barrières quaternaires InGaAsP non dopés ; composition des puits : $In_{0,8} Ga_{0,2} As_{0,73} P_{0,27}$, composition des barrières : $In_{0,8} Ga_{0,2} As_{044} P_{0,56}$ ,
    - une couche de confinement supérieure quaternaire InGaAsP dopée p, dont la composition est choisie pour présenter une longueur d'onde caractéristique égale à 1,18 µm, de 40nm d'épaisseur;

- couche tampon supérieure 3 constituée d'InP dopé p ($2.10^{18}$ trous par $cm^3$), ayant une épaisseur d'environ 3 µm;
- couche de contact 4 ternaire InGaAs fortement dopée p ($2.10^{19}$ trous par $cm^3$), ayant une épaisseur d'environ 0,3 µm;
- couche de tungstène 6 de 0,1 µm d'épaisseur;
- couche de métallisation 7 de 0,4 µm d'épaisseur;
- longueur du guide d'entrée GE : au moins 300 µm;
- largeur du guide d'entrée GE : 3 µm;
- longueur du segment de diffraction SD : 1 mm;
- longueur du segment de collimation SC : 150 µm
- longueur du guide amplificateur GA : 1 mm;
- largeur du dioptre et du guide amplificateur GA : 150 µm;
- largeur du composant : 600 µm.

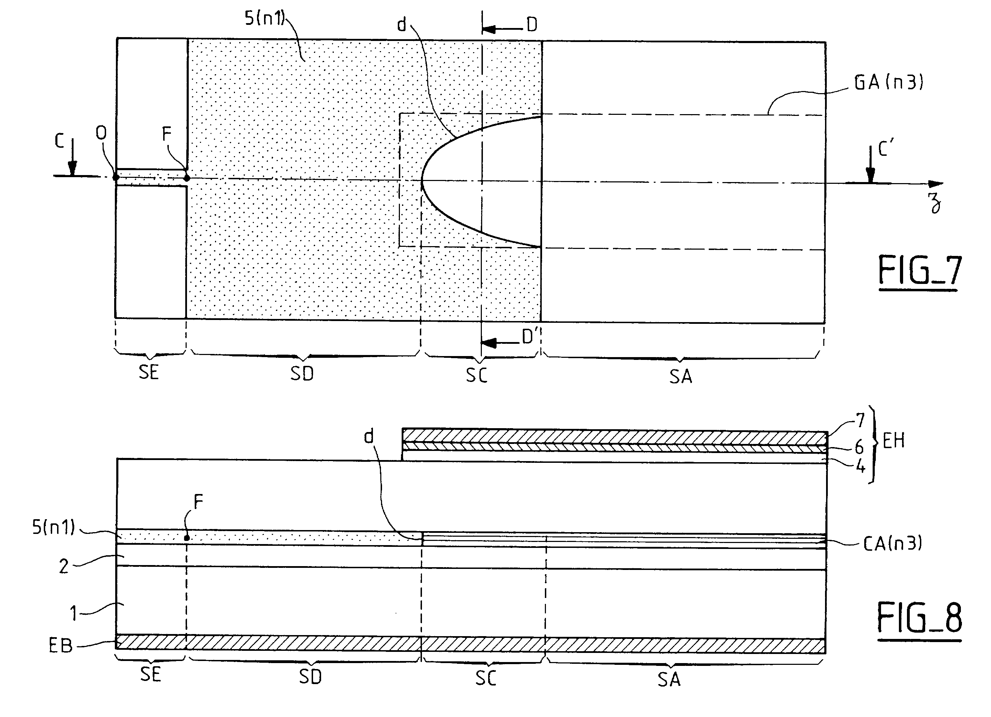

Les figures 7 à 9 représentent un second mode de réalisation de l'amplificateur selon l'invention. On retrouve comme précédemment le segment d'entrée SE, le segment de diffraction SD, le segment de collimation SC et le segment d'amplification SA.

Cette réalisation diffère de la précédente par le fait que le segment de collimation SC est réalisé par une jonction directe entre les segments de diffraction SD et d'amplification SA. Le dioptre d est alors constitué par la surface qui sépare le milieu 5 de la couche active CA. Comme la couche active CA a un indice effectif n3 supérieur à l'indice n1 de la couche 5, la concavité du dioptre d est inversée par rapport à celle de la réalisation précédente.

La structure verticale du composant apparaît sur la figure 8 qui est la coupe selon le plan vertical CC' passant par l'axe longitudinal Oz. On y retrouve les couches déjà décrites précédemment à l'exception de la couche 3'. Par ailleurs, on voit que l'électrode supérieure qui définit les dimensions du guide amplificateur GA recouvre entièrement le dioptre d. Elle peut même déborder au-dessus de la couche 5 car il s'agit d'un milieu passif dont l'indice effectif n1 n'est pas influencé par le courant qui le traverse.

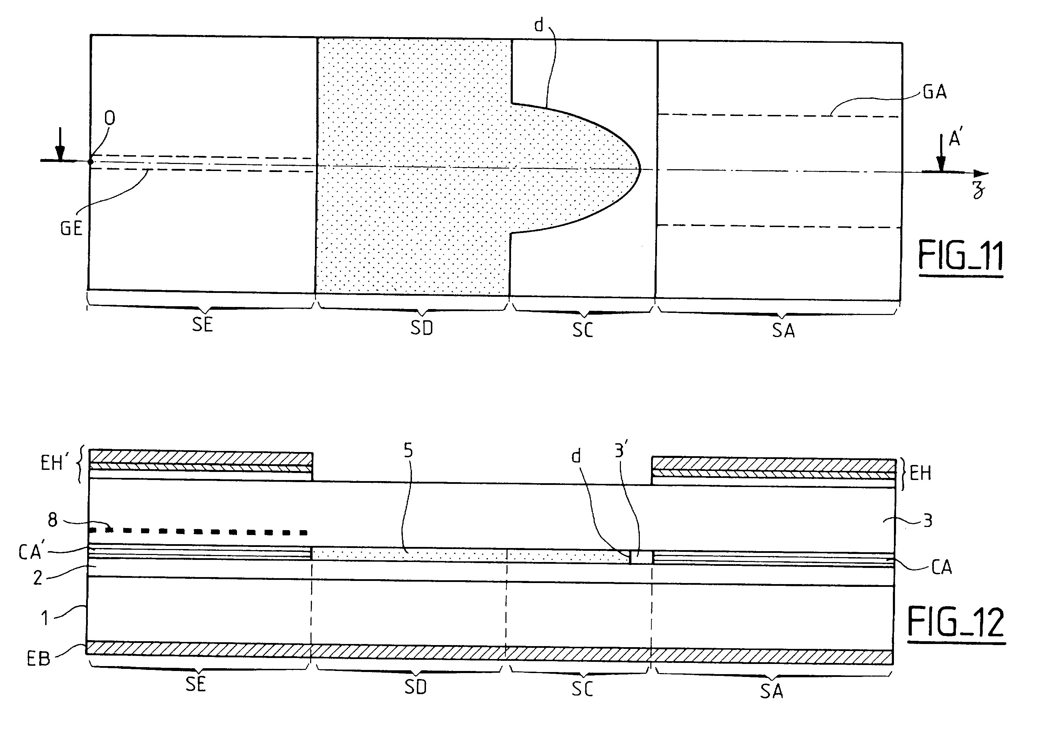

Pour compléter la description, la figure 9 représente une coupe selon le plan vertical transversal DD' situé dans le segment de collimation SC. On peut y voir la structure de l'électrode EH ainsi que la couche active CA qui est enterrée et délimitée latéralement par le milieu 5.

Comme précédemment, le schéma de la figure 10 permet d'expliquer le calcul de la courbe directrice du dioptre. En utilisant les mêmes notations que pour la figure 6, la courbe sera définie par l'ensemble des points M vérifiant :

n1.FM = n1.FP + n3.PM" , où M" est la projection de M sur le plan vertical longitudinal passant par P.

En coordonnées polaires, on a :

$$n1.(r-p) = n3.(r.\cos\theta - p)$$

n3 étant supérieur à n1, cette équation est celle d'une hyperbole de foyer F qui dépend des seuls paramètres n1, n3 et FP. Comme précédemment, connaissant n1 et n3 et en fixant une largeur voulue du guide amplificateur GA, on peut trouver au moins une valeur de FP qui convient et calculer la forme exacte du dioptre correspondant.

Pour réaliser un oscillateur laser à partir de l'un ou l'autre des modes de réalisation qui viennent d'être décrits, il suffit de lui associer des moyens réflecteurs permettant de constituer une cavité résonante contenant les quatre segments définis précédemment. Ces moyens sont par exemple constitués tout simplement des facettes clivées constituant les faces avant et arrière du composant. En variante, la cavité résonante peut être réalisée grâce à d'autres types de réflecteurs tels qu'un réseau de Bragg de façon à réaliser un oscillateur laser à contre-réaction distribuée ("DFB") ou des réflecteurs de Bragg distribués ("DBR") ou encore des réflecteurs externes.

Les figures 11 et 12 représentent un mode de réalisation d'une source laser intégrée conforme à l'invention. La figure 11 est une vue de dessus et la figure 12 une coupe selon le plan vertical AA' passant par l'axe longitudinal Oz du composant.

Comme pour l'amplificateur des figures 3 et 4, on retrouve les segments d'entrée SE, de diffraction SD, de collimation SC et d'amplification SA. Les segments SD, SC et SA sont identiques à ceux de l'amplificateur. Par contre, le segment d'entrée SE possède une électrode supérieure EH' et un guide d'entrée GE formé dans un milieu amplificateur CA'. Le guide GE est associé à des moyens réflecteurs 8. Dans l'exemple représenté, ces moyens sont constitués d'un réseau de Bragg de façon à réaliser un oscillateur laser à contre-réaction distribuée ("DFB"). L'électrode supérieure EH' est dimensionnée pour constituer un guide amplificateur GE de faible largeur. La couche active CA' a la même composition que la couche CA.

En variante, la cavité résonante peut être réalisée grâce à d'autres types de réflecteurs tels que la facette clivée du composant constituant sa face avant, un réflecteur externe et/ou des réflecteurs de Bragg distribués ("DBR").

La longueur du guide d'entrée GE sera par exemple de 1 mm.

Bien entendu la source laser intégrée peut être aussi réalisée avec la structure des segments SD, SC et SA de l'amplificateur des figures 7 et 8.

**Revendications**

1. Amplificateur optique semi-conducteur caractérisé en ce qu'il comporte successivement :

   - un segment d'entrée (SE) muni d'un guide d'entrée (GE) apte à guider une onde d'entrée monomode,
   - un segment de diffraction (SD) comprenant un premier milieu transparent (5) pour ladite onde d'entrée monomode et apte à l'élargir,
   - un segment de collimation (SC) , et
   - un segment d'amplification (SA) muni d'un guide amplificateur (GA) de largeur supérieure à celle dudit guide d'entrée (GE).

2. Amplificateur selon la revendication 1, caractérisé en ce que ledit segment de collimation (SC) comprend un dioptre (d) séparant ledit premier milieu (5) d'un second milieu transparent (3') d'indice effectif (n2) inférieur à celui (ni) du premier milieu (5).

3. Amplificateur selon la revendication 1, caractérisé en ce que ledit segment de collimation (SC) comprend un dioptre (d) séparant ledit premier milieu (5) d'un troisième milieu transparent (CA) d'indice effectif (n3) supérieur à celui (ni) du premier milieu (5).

4.  Amplificateur selon la revendication 3, caractérisé en ce que ledit troisième milieu (CA) est celui qui constitue le guide amplificateur (GA) dudit segment d'amplification (SA).

5.  Amplificateur selon l'une des revendications 1 à 4, caractérisé en ce que ledit guide amplificateur (GA) étant constitué d'une couche active (CA) de faible épaisseur, ledit premier milieu (5) est constitué d'une couche guidante couplée à ladite couche active (CA) et ledit dioptre (d) possède une surface cylindrique à génératrice perpendiculaire à ladite couche guidante.

6.  Oscillateur laser, caractérisé en ce qu'il est constitué d'un amplificateur optique semi-conducteur selon l'une des revendications 1 à 5 et de moyens réflecteurs pour former une cavité résonante.

7.  Source laser intégrée semi-conductrice, caractérisée en ce qu'elle est comporte un amplificateur optique semi-conducteur selon l'une des revendications 1 à 5 et en ce que ledit guide d'entrée (GE) est constitué d'un milieu amplificateur (CA') associé à des moyens réflecteurs (8) pour former une cavité résonante d'un oscillateur laser.

FIG_1

FIG_2

FIG_3

GA(n3)

A'

3'(n2)

B

d

5(n1)

F

O

GE

A

SA SC SD SE

FIG_4

7 6 4 } EH

CA(n3)

3'

d

SA SC SD SE

F

3

5(n1)

2

1

EB

FIG_5

FIG_6

FIG_9

FIG_10

EP 0 915 543 A1

5(n1)

d

D

GA(n3)

C

O

F

C'

z

D'

SE

SD

SC

SA

<u>FIG_7</u>

7
6
4

EH

d

F

5(n1)

2

1

EB

CA(n3)

SE

SD

SC

SA

<u>FIG_8</u>

FIG_11

FIG_12

EP 0 915 543 A1

Office européen
des brevets

**RAPPORT DE RECHERCHE EUROPEENNE**

Numéro de la demande

EP 98 40 2772

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | US 5 539 571 A (WELCH DAVID F ET AL) 23 juillet 1996<br>* colonne 6, ligne 32-55 *<br>* colonne 10, ligne 27 - colonne 14, ligne 35; figures 14,15,30-33 *<br>--- | 1-7 | H01S3/25 |
| A | WO 96 09668 A (BRITISH TELECOMM ;DAVIES DAVID ARTHUR OWEN (GB)) 28 mars 1996<br>* page 5-13; figures 1,7-9 *<br>--- | 1-7 | |
| A | VERDIELL J - M ET AL: "A WDM RECEIVER PHOTONIC INTEGRATED CIRCUIT WITH NET ON-CHIP GAIN"<br>IEEE PHOTONICS TECHNOLOGY LETTERS,<br>vol. 6, no. 8, 1 août 1994, pages 960-962,<br>XP000465494<br>* figure 1 *<br>--- | 1-7 | |
| A | US 4 815 084 A (SCIFRES DONALD R ET AL) 21 mars 1989<br>* figure 7 *<br>--- | 1-7 | |
| | | | DOMAINES TECHNIQUES RECHERCHES (Int.Cl.6) |
| A | LIOU K -Y ET AL: "HIGH-POWER BROAD-AREA TAPERED AMPLIFIER WITH A MONOLITHICALLY INTEGRATED OUTPUT FOCUSING LENS AT 0.98-UM WAVELENGTH"<br>IEEE JOURNAL OF SELECTED TOPICS IN QUANTUM ELECTRONICS,<br>vol. 1, no. 2, 1 juin 1995, pages 165-172,<br>XP000521081<br>* figure 1 *<br>---<br>-/-- | 1-7 | H01S |

Le présent rapport a été établi pour toutes les revendications

| Lieu de la recherche | Date d'achèvement de la recherche | Examinateur |
|---|---|---|
| LA HAYE | 15 février 1999 | Claessen, L |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

# EP 0 915 543 A1

**Office européen des brevets**

## RAPPORT DE RECHERCHE EUROPEENNE

Numéro de la demande

EP 98 40 2772

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | DONNELLY J P ET AL: "HIGH-POWER 1.3-MUM INGAASP-INP AMPLIDERS WITH TAPERED GAIN REGIONS"<br>IEEE PHOTONICS TECHNOLOGY LETTERS,<br>vol. 8, no. 11, novembre 1996, pages 1450-1452, XP000632625<br>* figure 1 *<br>----- | 1 | |
| | | | **DOMAINES TECHNIQUES RECHERCHES (Int.Cl.6)** |

Le présent rapport a été établi pour toutes les revendications

| Lieu de la recherche | Date d'achèvement de la recherche | Examinateur |
|---|---|---|
| LA HAYE | 15 février 1999 | Claessen, L |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 98 40 2772

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

15-02-1999

| Document brevet cité au rapport de recherche | Date de publication | Membre(s) de la famille de brevet(s) | Date de publication |
|---|---|---|---|
| US 5539571 A | 23-07-1996 | US 5793521 A | 11-08-1998 |
| WO 9609668 A | 28-03-1996 | CA 2199510 A<br>EP 0781465 A<br>JP 10505954 T | 28-03-1996<br>02-07-1997<br>09-06-1998 |
| US 4815084 A | 21-03-1989 | AUCUN | |

EPO FORM P0460

Pour tout renseignement concernant cette annexe : voir Journal Officiel de l'Office européen des brevets, No.12/82